# DEMANDE DE BREVET EUROPEEN

(11) **EP 3 480 850 A1**
(43) Date de publication de la demande: **08.05.2019**
(21) Numéro de dépôt: 18204634.2
(22) Date de dépôt: 06.11.2018
(51) Int. Cl.: H01L 27/146, H01L 21/52

(54) **PROCEDE DE REALISATION DE CIRCUITS ELECTRONIQUES COURBES**

(30) Priorité: 07.11.2017 FR 1760450
(71) Demandeur: Commissariat à l'énergie atomique et aux énergies alternatives, 75015 Paris (FR)
(72) Inventeur: CHAMBION, Bertrand, 38530 PONTCHARRA (FR); CAPLET, Stéphane, 38360 SASSENAGE (FR)
(74) Mandataire: Brevalex

(57) **Abrégé**

Procédé de réalisation collective de plusieurs circuits électroniques courbés, comprenant :
- mise en place de plusieurs éléments adhésifs (124) entre plusieurs puces électroniques (116) et plusieurs surfaces d'appui courbées (122), et avec les puces disposée entre les surfaces d'appui courbées et un film souple (102), et tel que les puces, les éléments adhésifs et les surfaces d'appui courbées soient disposés dans un seul volume (128) apte à être mis en dépression vis-à-vis de l'environnement extérieur au volume et incluant des espaces vides (129) présents entre les puces électroniques et les surfaces d'appui courbées ;
- établissement d'une différence de pression entre l'intérieur et l'extérieur du volume telle que le film souple applique sur les puces une pression les déformant conformément aux surfaces d'appui courbées ;
- arrêt de l'application de la différence de pression, les puces courbées étant maintenues contre les surfaces d'appui courbées par les éléments adhésifs.

## Description

### DOMAINE TECHNIQUE ET ART ANTÉRIEUR

L'invention concerne la réalisation de plusieurs circuits électroniques courbés, c'est-à-dire non plans, ainsi que celui de la réalisation de dispositifs électroniques comportant de tels circuits électroniques courbés couplés à des systèmes optiques, par exemple de type imageur (ou capteur) ou afficheur. L'invention concerne la réalisation collective de plusieurs circuits électroniques courbés.

Un dispositif électronique tel qu'un capteur ou un afficheur comporte un système optique, formé généralement de plusieurs lentilles, couplé à un circuit électronique destiné à réaliser une émission ou une détection de lumière à travers le système optique. Le circuit électronique comporte un substrat sur lequel sont réalisés plusieurs composants électroniques formant une puce électronique.

Le fait de courber le circuit électronique est une solution qui permet de simplifier fortement le système optique, en réduisant notamment le nombre de lentilles nécessaires au système optique, ce qui permet une réalisation plus compacte du système optique. Un exemple de simplification d'optique grand angle est décrit par exemple dans le document « Tunable curvature of large visible CMOS image sensors: Towards new optical functions and system miniaturization » de B. Chambion et al., 2016 IEEE 66th Electronic Components and Technology Conférence (ECTC).

Les substrats à partir desquels les composants électroniques des circuits sont réalisés sont généralement en silicium. Les techniques et procédés de packaging permettent de réduire l'épaisseur du substrat jusqu'à des épaisseurs relativement faibles (quelques microns). Pour réaliser un circuit électronique courbé, une fois le substrat des composants du circuit aminci à l'épaisseur voulue, le circuit électronique est packagé, ou assemblé, sur un support qui est compatible avec la courbure recherchée.

Dans le document précédemment cité de B. Chambion et al, il est décrit un support particulier sur lequel le circuit électronique est collé. La courbure est ensuite obtenue en appliquant ponctuellement une force contre le support, au centre du côté opposé à celui où se trouve le circuit électronique. Dans ce procédé, il est toutefois nécessaire que la force courbant le support soit constamment appliquée sur le support, ce qui représente une contrainte importante.

Le document US 2014/0160327 A1 décrit l'utilisation d'un support dans lequel est formée une cavité. Un circuit électronique est disposé sur le support, au-dessus de la cavité. Le circuit est ensuite courbé sous l'effet d'un traitement thermique. La courbure peut être ajustée via une mise en dépression de la cavité, et le circuit est ensuite figé dans la position courbée obtenue par l'intermédiaire de colle injectée entre le circuit et le support dans la cavité. Cette solution a toutefois pour inconvénient d'engendrer des contraintes mécaniques importantes au niveau des bords du circuit électronique qui reposent sur le support, ce qui le fragilise. De plus, ce procédé présente l'inconvénient de ne pas maîtriser la forme finale du circuit courbé obtenu dans la cavité.

De manière alternative, le document WO 2012/172251 A1 décrit la réalisation d'un circuit électronique courbé faisant appel à un support formé de deux matériaux ayant des coefficients d'expansion thermique différents. La courbure est obtenue par un effet bilame entre les deux matériaux du support qui ont des comportements thermomécaniques différents. Ce procédé n'est toutefois pas adapté à une réalisation collective de plusieurs circuits électroniques courbés puisque les différents circuits électroniques réalisés à partir d'un même substrat doivent être découpés avant d'être disposés individuellement chacun sur un support. De plus, le choix du niveau de courbure des circuits se fait par ajustement de la température à laquelle le support est soumis, ce qui est contraignant notamment lorsque le circuit électronique correspond à un imageur du fait que son fonctionnement est extrêmement sensible à la température (une augmentation de la température réalisée pour ajuster la courbure du circuit dégrade la qualité de l'image fournie par l'imageur en raison de l'augmentation du bruit engendrée par l'augmentation de la température).

Les documents US 2011/0149423 A1, US 2009/0045510 A1 et EP 2 320 469 A1 décrivent d'autres procédés permettant de courber des circuits électroniques. Toutefois, aucun de ces procédés n'est adapté pour réaliser collectivement plusieurs circuits électroniques courbés.

Le document US 2006/0038183 A1 décrit un procédé permettant de courber collectivement plusieurs circuits électroniques réalisés sur un même substrat. Pour cela, un compartiment contenant un fluide est positionné sous chaque circuit de façon à appliquer une force hydrostatique sous chaque circuit. La courbure des circuits est obtenue par l'intermédiaire de cette force hydrostatique. Ce procédé a toutefois plusieurs inconvénients. En effet, la courbure obtenue varie avec la température à laquelle le fluide est soumis. Il est donc difficile d'obtenir une courbure précise des circuits électroniques. De plus, cette solution n'est pas fiable car en cas de fuite du fluide, la courbure des circuits doit être réajustée.

### EXPOSÉ DE L'INVENTION

Un but de la présente invention est de proposer un procédé de réalisation collective de plusieurs circuits électroniques courbés qui ne présente pas les inconvénients des procédés de l'art antérieur précédemment décrits.

Pour cela, il est décrit un procédé de réalisation d'au moins un circuit électronique courbé, comprenant :
- mise en place d'au moins un élément adhésif entre au moins une puce électronique et au moins une surface d'appui courbée, avec la puce électronique disposée entre la surface d'appui courbée et un film souple, et tel que la puce électronique, l'élément adhésif et la surface d'appui courbée soient disposés dans un volume apte à être mis en dépression vis-à-vis de l'environnement extérieur au volume ;
- établissement d'une différence de pression entre l'intérieur et l'extérieur du volume telle que le film souple applique sur la puce électronique une pression la déformant conformément à la surface d'appui courbée ;
- arrêt de l'application de la différence de pression entre l'intérieur et l'extérieur du volume, la puce électronique courbée étant maintenue contre la surface d'appui courbée par l'élément adhésif.

L'invention propose notamment un procédé de réalisation collective de plusieurs circuits électroniques courbés, comprenant :
- mise en place de plusieurs éléments adhésifs entre plusieurs puces électroniques et plusieurs surfaces d'appui courbées, avec les puces électroniques disposées entre les surfaces d'appui courbées et un film souple, et tel que les puces électroniques, les éléments adhésifs et les surfaces d'appui courbées soient disposés dans un seul volume apte à être mis en dépression vis-à-vis de l'environnement extérieur au volume et incluant des espaces vides présents entre les puces électroniques et les surfaces d'appui courbées ;
- établissement d'une différence de pression entre l'intérieur et l'extérieur du volume telle que le film souple applique sur les puces électroniques une pression les déformant conformément aux surfaces d'appui courbées ;
- arrêt de l'application de la différence de pression entre l'intérieur et l'extérieur du volume, les puces électroniques courbées étant maintenues contre les surfaces d'appui courbées par les éléments adhésifs.

Dans ce procédé, du fait que la force est appliquée par pression contre l'une des faces principales de la ou des puces électroniques et non au niveau des côtés, ou faces latérales, de celle(s)-ci, une déformation similaire peut être obtenue simultanément pour plusieurs puces électroniques, ce qui rend le procédé compatible avec une réalisation collective de plusieurs circuits électroniques courbés. Une réalisation collective de plusieurs circuits électroniques courbés est également possible du fait qu'il n'est pas nécessaire de disposer individuellement chaque puce électronique sur un support distinct pour courber les puces électroniques.

En outre, ce procédé ne fait pas appel à des matériaux ayant différents CTE (coefficient d'expansion thermique) pour obtenir la courbure souhaitée par effet bilame, ce qui rend la courbure du ou des circuits électroniques indépendante de la température à laquelle est soumis le ou les circuits électroniques. La courbure obtenue est également plus stable grâce au fait que la surface d'appui utilisée est courbée et définit la courbure du circuit électronique réalisé. Enfin, la courbure du ou des circuits électroniques n'est pas impactée par une température importante à laquelle serait soumis le ou les circuits électroniques.

De plus, contrairement au procédé décrit dans le document US 2014/0160327 A1 dans lequel les bords de la puce électronique courbée reposent sur les bords du support, les bords de la puce électronique courbée par le procédé selon l'invention sont libres et les contraintes mécaniques subies par la puce électronique lors de sa courbure sont bien réparties dans l'ensemble de la puce. Sans encastrement, les bords de la puce électronique ne sont ainsi pas soumis à des contraintes locales plus importantes que dans le reste de la puce.

Ce procédé ne fait pas appel à un fluide pour obtenir la courbure souhaitée, ce qui augmente la fiabilité du procédé.

Ce procédé est compatible avec une courbure concave ou convexe de la puce électronique du circuit électronique courbé réalisé. D'autres formes de courbure sont également envisageables, comme par exemple : elliptique, portion de tore, forme libre. N'importe quelle forme de courbure est envisageable, sous réserve que cette courbure n'engendre pas de rupture mécanique de la puce électronique.

Les puces électroniques, les éléments adhésifs et les surfaces d'appui courbées sont disposés dans un seul volume apte à être mis en dépression vis-à-vis de l'environnement extérieur au volume et incluant des espaces vides présents entre les puces électroniques et les surfaces d'appui courbées, c'est-à-dire un seul espace dans lequel l'air peut circuler librement dans toutes les parties de cet espace. L'air peut notamment circuler librement dans les espaces vides présents entre les puces électroniques et les surfaces d'appui courbées et entre ces espaces vides. Plusieurs volumes distincts ne forment pas ensemble un seul volume tel que défini ci-dessus.

De manière avantageuse, l'établissement de la différence de pression entre l'intérieur et l'extérieur du volume peut comporter l'établissement d'un vide à l'intérieur du volume.

Le film souple correspond à une fine couche apte à se déformer sous l'effet de la différence de pression et à contraindre la puce électronique selon la surface d'appui courbée.

Le film souple peut former au moins une partie des parois délimitant le volume apte à être mis en dépression. En variante, le film souple peut être inclus dans le volume apte à être mis en dépression vis-à-vis de l'environnement extérieur, notamment lorsque le volume est délimité par au moins une paroi souple apte à venir faire appui sur le film souple lors de la mise en dépression du volume.

Avant l'établissement de la différence de pression entre l'intérieur et l'extérieur du volume, la surface d'appui courbée peut être disposée entre la puce électronique et un support rigide, le volume étant formé au moins par le support rigide et le film souple solidarisé au support rigide, la différence de pression entre l'intérieur et l'extérieur du volume étant réalisée par l'intermédiaire d'au moins une ouverture traversant le support rigide et/ou de pores du matériau du support rigide.

Avant l'établissement de la différence de pression entre l'intérieur et l'extérieur du volume, les surfaces d'appui courbées peuvent être disposées entre les puces électroniques et un support rigide, le volume pouvant être formé au moins par le support rigide et le film souple solidarisé au support rigide, la différence de pression entre l'intérieur et l'extérieur du volume pouvant être réalisée par l'intermédiaire d'au moins une ouverture traversant le support rigide et/ou de pores du matériau du support rigide.

Le procédé peut comporter en outre, après l'arrêt de l'application de la différence de pression entre l'intérieur et l'extérieur du volume, une étape de retrait du support rigide.

De manière alternative, le volume peut être délimité par une paroi souple. Cette paroi souple a par exemple une forme de sachet dans lequel sont disposés la ou les puces électroniques, le ou les éléments formant les surfaces d'appui courbées, le ou les éléments adhésifs et le film souple.

Le procédé peut comporter en outre, avant l'établissement de la différence de pression entre l'intérieur et l'extérieur du volume, une mise en place d'une contre-cale telle que la puce électronique soit disposée entre la surface d'appui courbée et la contre-cale, la contre-cale pouvant avoir une surface courbée disposée contre la puce électronique lors de l'établissement de la différence de pression entre l'intérieur et l'extérieur du volume. A l'établissement de la différence de pression entre l'intérieur et l'extérieur du volume, la surface courbée de la contre-cale vient donc appuyer sur la puce électronique, contribuant ainsi à la mise en courbure de la puce électronique.

Le procédé peut comporter en outre, avant l'établissement de la différence de pression entre l'intérieur et l'extérieur du volume, une mise en place de contre-cales telles que les puces électroniques soient disposées entre les surfaces d'appui courbées et la ou les contre-cales, et les contre-cales peuvent avoir des surfaces courbées disposées contre les puces électroniques lors de l'établissement de la différence de pression entre l'intérieur et l'extérieur du volume.

La surface d'appui courbée peut correspondre à une surface d'une cale ou à une surface intérieure d'un boîtier dans lequel la puce électronique est destinée à être encapsulée. Les surfaces d'appui courbées peuvent correspondre à des surfaces de cales ou à des surfaces intérieures de boîtiers dans lesquels les puces électroniques sont destinées à être encapsulées.

Plusieurs circuits électroniques courbés peuvent être réalisés collectivement à partir de plusieurs puces électroniques maintenues contre plusieurs surfaces d'appui courbées.

Dans ce cas, plusieurs cales distinctes et espacées ou non les unes des autres, ou plusieurs boîtiers distincts et espacés ou non les uns des autres, peuvent être utilisés pour former les surfaces d'appui courbées. Ainsi, lors de l'établissement de la différence de pression un ou plusieurs canaux d'échappement formés entre les cales ou boîtiers permettent d'avoir une circulation d'air à l'intérieur du volume. De manière alternative ou complémentaire, cette circulation d'air peut être obtenue grâce à une encoche présente dans le volume, au niveau de la périphérie du volume, par exemple formée dans le support rigide.

Lorsque les puces électroniques sont réalisées contre le film souple, le procédé peut comporter en outre, avant l'étape de mise en place, un étirement, isotrope ou non, du film souple engendrant un espacement des puces électroniques les unes des autres, le film souple étant maintenu étiré lors de l'étape de mise en place.

Les puces électroniques peuvent être réalisées contre le film souple via la mise en oeuvre des étapes suivantes :
- solidarisation du film souple contre un substrat semi-conducteur, du côté de composants électroniques réalisés sur le substrat semi-conducteur et destinés à former les puces électroniques ;
- découpe du substrat semi-conducteur, formant les puces électroniques.

Dans ce cas, entre les étapes de solidarisation et de découpe, le substrat peut subir une étape d'amincissement.

En variante, lorsque la ou les puces électroniques ne sont pas réalisées contre le film souple, la ou les puces électroniques peuvent être disposées contre la ou les surfaces d'appui courbées de manière unitaire.

Le ou les éléments formant les surfaces d'appui courbées peuvent être solidaires du support rigide.

En variante, l'étape de mise en place peut comporter :
- une solidarisation du film souple contre un support temporaire telle que le film souple soit disposé entre la ou les puces électroniques et le support temporaire ;
- une disposition de la ou des surface d'appui courbées en regard de la ou des puces électroniques ;
- une disposition d'un support rigide tel qu'il forme, avec le film souple, ledit volume ;
- un retrait du support temporaire.

Le ou les éléments adhésifs peuvent être disposés contre la ou les puces électroniques et/ou contre la ou les surfaces d'appui courbées.

Il est également proposé un procédé de réalisation d'au moins un dispositif électronique, comportant la mise en oeuvre d'un procédé de réalisation d'au moins un circuit électronique tel que décrit ci-dessus, puis d'une étape de couplage optique du circuit électronique avec un système optique, formant le dispositif électronique.

L'invention concerne également un procédé de réalisation d'au moins un dispositif électronique, comportant la mise en oeuvre d'un procédé de réalisation de circuits électroniques tels que décrits ci-dessus, puis d'une étape de couplage optique d'au moins un des circuits électroniques avec un système optique, formant le dispositif électronique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1J représentent les étapes d'un procédé de réalisation d'au moins un circuit électronique courbé, objet de la présente invention, selon un premier mode de réalisation ;
- les figures 2A à 2D représentent une partie des étapes d'un procédé de réalisation d'au moins un circuit électronique courbé, objet de la présente invention, selon un deuxième mode de réalisation ;
- les figures 3A à 3D représentent une partie des étapes d'un procédé de réalisation d'au moins un circuit électronique courbé, objet de la présente invention, selon un troisième mode de réalisation ;
- la figure 4 représente un dispositif électronique réalisé avec un circuit électronique courbé obtenu par la mise en oeuvre d'un procédé de réalisation selon l'invention ;
- les figures 5 et 6 représentent des variantes de mise en oeuvre d'un procédé de réalisation d'au moins un circuit électronique courbé, objet de la présente invention ;
- la figure 7 représente une structure obtenue au cours de la mise en oeuvre du procédé de réalisation selon une variante du premier mode de réalisation ;
- la figure 8 représente une structure obtenue au cours de la mise en oeuvre du procédé de réalisation selon une autre variante de réalisation ;
- la figure 9 représente une vue de dessus d'une puce électronique disposée sur une surface d'appui courbée.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

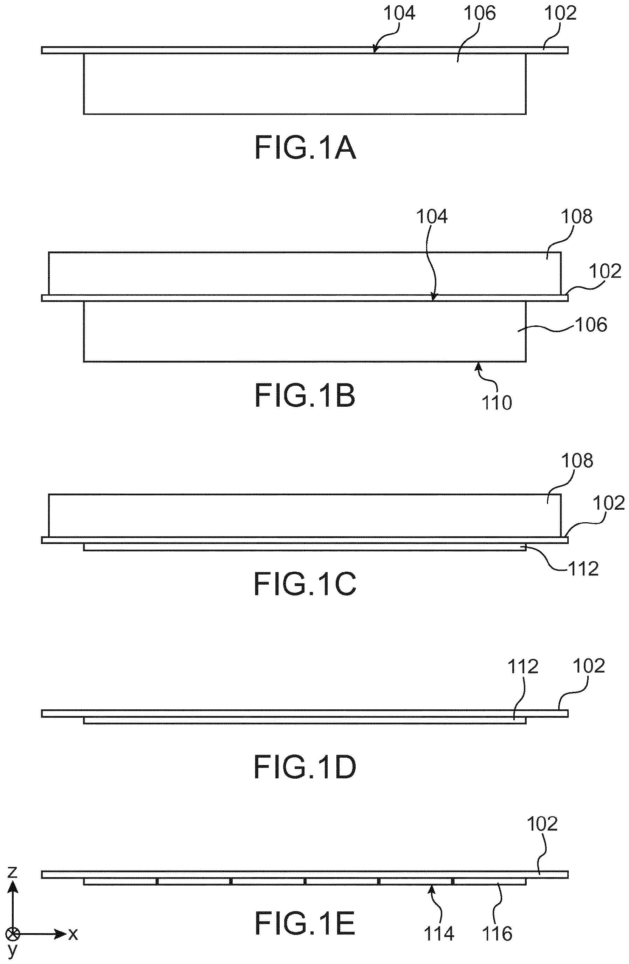

Les figures 1A à 1J représentent les étapes d'un procédé de réalisation d'au moins un circuit électronique courbé 100, selon un premier mode de réalisation. Dans ce premier mode de réalisation, plusieurs circuits électroniques 100 correspondants à des imageurs CMOS sont réalisés. En variante, le ou les circuits électroniques 100 peuvent correspondre à des imageurs CCD ou tout autre circuit électronique.

Au cours d'une première étape représentée sur la figure 1A, un film souple 102 est solidarisé à une première face 104 d'un substrat semi-conducteur 106. Ce film 102 est destiné à protéger les puces électroniques qui seront réalisées à partir du substrat 106, à supporter et manipuler ces puces électroniques, ainsi qu'à contribuer à la mise en courbure de ces puces électroniques mise en oeuvre au cours du procédé.

Les composants électroniques des circuits électroniques 100 sont réalisés au préalable sur le substrat semi-conducteur 106 et se trouvent du côté de la première face 104 qui correspond à la face avant du substrat 106. Ces composants électroniques forment par exemple des capteurs d'image.

Le film souple 102 est caractérisé par son aptitude à pouvoir s'étirer sans rompre. L'allongement à la rupture du film souple 102 est d'au moins 1 %, et de préférence supérieur à environ 10 %. L'allongement à la rupture du film souple 102 peut être encore plus important, et atteindre par exemple environ 500 %.

Le film souple 102 peut comporter des composés de la famille des polyoléphines et/ou de la famille des polysiloxanes. Comme autres exemples, le film 102 peut correspond à un film de type Adwill® D-650, D-675 ou E-8180HR, commercialisés par la société Lintec®.

La nature du film souple 102 est choisie notamment en fonction de l'étirement que doit subir ce film souple 102 pour courber les puces électroniques. Ainsi, plus le rayon de courbure à atteindre est faible et/ou plus les puces électroniques sont petites, plus le film souple 102 doit présenter une aptitude à s'étirer importante.

Le film souple 102 est en outre étanche.

L'allongement que peut subir le film 102 peut être réversible ou non. Ainsi, le film souple 102 peut avoir des propriétés élastiques. Dans le premier mode de réalisation décrit ici, le film 102 comporte au moins un matériau élastique qui permettra, au cours du procédé, d'être étiré et d'espacer les puces électroniques qui seront réalisées à partir du substrat 106.

Le film 102 comporte une épaisseur par exemple comprise entre environ 50 µm et 100 µm, ou entre environ 50 µm et 200 µm.

Le substrat 106 peut comporter au moins un matériau semi-conducteur. Dans le premier mode de réalisation décrit ici, le substrat 106 correspond à un wafer de silicium. L'épaisseur du substrat 106 correspond à l'épaisseur standard d'un wafer de silicium, par exemple égale à environ 725 µm.

De manière optionnelle, le substrat 106 peut subir un amincissement. Pour cela, un support temporaire 108 est solidarisé au film 102, du côté opposé à celui en contact avec le substrat 106 (figure 1B).

Le substrat 106 est ensuite aminci depuis une deuxième face 110, opposée à la première face 104, jusqu'à l'obtention d'une couche 112 formée par la partie restante du substrat 106 et dont l'épaisseur correspond à l'épaisseur de semi-conducteur souhaitée, par exemple environ 100 µm (figure 1C). Cet amincissement est par exemple réalisé en mettant en oeuvre successivement un premier meulage grossier afin de retirer rapidement une partie importante du substrat 106, puis un deuxième meulage fin permettant d'affiner l'épaisseur restante du matériau du substrat 106, puis une planarisation mécano-chimique (CMP) ou une gravure sèche ou tout autre procédé permettant de retirer la zone écrouie du substrat 106. L'épaisseur de la couche 112 est par exemple inférieure à environ 400 µm, et typiquement inférieure à environ 100 µm. Cet amincissement peut également être mis en oeuvre tel que l'épaisseur de la couche 112 soit de quelques microns, par exemple inférieure ou égale à environ 10 µm. Lorsque le substrat 106 comporte une couche d'arrêt comprenant par exemple du SiO₂ et disposée entre une couche superficielle dans laquelle les composants électroniques sont réalisés et une couche support, l'amincissement peut être réalisé tel que la couche support soit complètement supprimée. C'est le cas lorsque le substrat 106 est un substrat SOI.

L'amincissement du substrat 106 décrit ci-dessus est facultatif, et il est possible de poursuivre le procédé avec un substrat 106 non aminci, notamment lorsque le substrat 106 est destiné à former une seule et très grande puce électronique.

Le support temporaire 108 est ensuite retiré (figure 1D).

La couche 112 est ensuite découpée sous la forme de puces électroniques 116 chacune destinée à former un des circuits électroniques 100 (figure 1E). Les puces électroniques 116 ont des dimensions latérales (parallèles à l'interface entre la couche 112 et le film 102, ou bien parallèles au plan (X,Y) représenté sur la figure 1E) dépendant de l'application envisagée. Cette étape de découpe est mise en oeuvre depuis une face 114 de la couche 112, opposée à la face 104. Lorsque la couche 112 est transparente aux rayons infrarouges, comme par exemple lorsque la couche 112 est à base de silicium, la localisation des chemins de découpe peut être réalisée par imagerie infrarouge à travers la couche 112 du fait que la face avant 104 n'est pas accessible par imagerie dans le domaine visible.

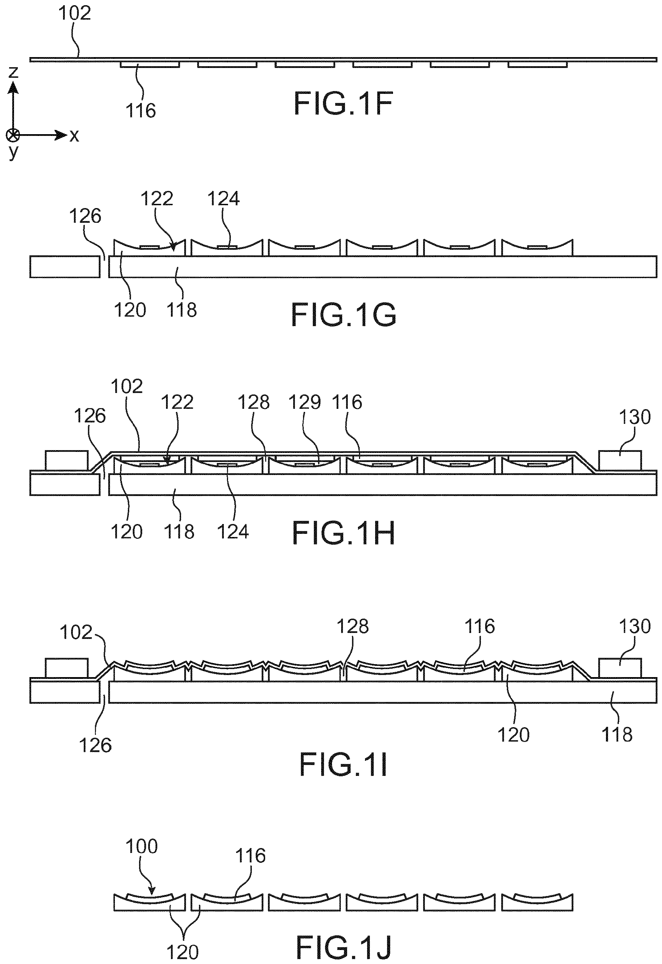

Comme représenté sur la figure 1F, le film 102 est ensuite étiré selon une ou plusieurs directions appartenant au plan principal du film 102, c'est-à-dire parallèlement aux interfaces entre le film 102 et les puces électroniques 116 (parallèlement au plan (X,Y)), afin d'espacer les puces électroniques 116 les unes des autres et réaliser ensuite un report direct des puces électroniques 116 et du film 102 sur les supports souhaités.

Dans ce premier mode de réalisation, les puces électroniques 116 sont destinées à être reportées collectivement sur un support 118 sur lequel sont disposées des cales 120 (voir exemple de réalisation représenté sur la figure 1G). Le support 118 est ici rigide. Chacune des cales 120 comporte une surface d'appui courbée 122 sur laquelle l'une des puces électroniques 116 est destinée à être reportée et solidarisée (par exemple collée). La surface d'appui courbée 122 de chaque cale 120 présente des dimensions supérieures ou égales à celles de chacune des puces électroniques 116. Un élément adhésif 124, par exemple de la colle, est disposé sur la surface d'appui courbée 122 de chacune des cales 120. Les cales 120 sont par exemple réalisées par moulage, usinage ou impression 3D, ou bien correspondent à des portions de céramique destinées à faire partie des structures d'encapsulation finales des circuits électroniques 100. Les cales 120 peuvent également être monolithiques, par exemple en métal usiné, ou en polymère moulé et formant une matrice de boîtiers QFN (« Quad Flat package No leads »). Les espaces présents entre les cales 120 permettent d'avoir une circulation d'air entre elles. Il est également possible d'avoir au moins une rainure formée dans le support 118, du côté des cales 120, pour permettre une circulation d'air.

En variante, il est possible d'avoir une seule cale 120 comportant plusieurs surfaces d'appui courbées 122 sur lesquelles les différentes puces électroniques 116 sont destinées à être reportées.

Le support 118 comporte également une ou plusieurs ouvertures 126 traversant le support 118, mettant en communication les deux faces principales du support 118.

Comme représenté sur la figure 1H, l'ensemble formé du film 102 et des puces électroniques 116 est reporté sur le support 118, du côté des cales 120. Chacune des puces électroniques 116 est disposée contre la surface d'appui courbée 122 d'une des cales 120. Les bords du film 102 sont solidarisés de manière étanche au support 118 afin que le film 102 et le support 118 forment un volume 128 dans lequel les puces électroniques 116, les cales 120 et les éléments adhésifs 124 se retrouvent enfermés. Ce volume 128 communique avec l'environnement extérieur uniquement à travers la ou les ouvertures 126. Dans l'exemple de réalisation représenté sur la figure 1H, les bords du film 102 sont solidarisés au support 118 grâce à un anneau 130 plaquant de manière étanche les bords du film 102 au support 118. Le volume 128 inclut des espaces vides 129 présents entre les puces électroniques 116 et les surfaces d'appui courbées 122 des cales 120. Ces espaces vides 129 communiquent entre eux et avec le reste du volume 128 du fait que les puces électroniques 116 ne sont pas en appui sur les surfaces d'appui courbées 122 sur toute la périphérie de leur bord. C'est par exemple le cas lorsque chaque puce électronique 116 a une forme parallélépipédique rectangle et que les surfaces d'appui courbées 122 des cales 120 sont concaves et par exemple sphérique ou cylindrique.

Afin de courber les puces électroniques 116, une différence de pression est établie entre les deux côtés du film 102, c'est-à-dire ici entre l'intérieur du volume 128 et le côté du film 102 opposé à celui où se trouvent les puces électroniques 116. Dans ce premier mode de réalisation, un vide, par exemple un vide primaire (pression comprise entre environ 1 et 10⁻³ mbar), est créé dans le volume 128 par l'intermédiaire de l'ouverture 126. La création de cette différence de pression engendre un plaquage du film 102 contre les surfaces d'appui courbées 122 des cales 120. Les puces électroniques 116 se retrouvent plaquées contre ces surfaces d'appui courbées 122 des cales 120 et épousent leur forme en raison de la force hydrostatique appliquée par le film 102, grâce à la dépression créée au sein du volume 128 (figure 1I).

Il est également possible que cette force hydrostatique soit engendrée par une surpression créée du côté du film 102 opposé à celui où se trouvent les puces électroniques 116, cette surpression remplaçant la dépression dans le volume 128 ou étant complémentaire de cette dépression.

Lorsque les éléments adhésifs 124 correspondent à des portions de colle, cette colle est alors réticulée, soit à température ambiante, soit en mettant en oeuvre un cycle thermique, permettant de solidariser les puces électroniques 116 aux surfaces d'appui courbées 122 des cales 120 et ainsi maintenir les puces électroniques 116 selon cette forme courbe. La mise en oeuvre d'un cycle thermique pour réticuler la colle facilite en outre la mise en courbure des puces électroniques 116 du fait que l'élévation de température fluidifie la colle et assouplie le film 102, favorisant le placage des puces électroniques 116 sur les surfaces d'appui courbées 122.

Une fois la colle réticulée, la remise à l'air est effectuée en stoppant la différence de pression créée de chaque côté du film 102. Le film 102 est retiré, par exemple par traitement UV ou par pelage. Dans le cas d'une matrice monolithique de cales 120, une étape de découpe est mise en oeuvre afin de séparer unitairement les circuits électroniques 100 réalisés et formés chacun d'une puce électronique 116 courbée et de la cale 120 associée. Les cales 120 peuvent également être dissociées du support rigide 118 (figure 1J).

A l'issue de ces étapes, les circuits électroniques 100 peuvent être mis en boîtier individuellement. Des contacts électriques d'entrée et de sortie reliés aux puces électroniques 116 peuvent également être réalisés.

Dans le premier mode de réalisation précédemment décrit, les éléments adhésifs 124 sont disposés sur les surfaces d'appui courbées 122 des cales 120 afin de solidariser les puces électroniques 116 aux cales 120. En variante, les éléments adhésifs 124 peuvent être déposés sur les puces électroniques 116, par exemple par sérigraphie lorsque les éléments adhésifs 124 sont des portions de colle, ou toute autre technique de dépôt en face arrière.

De plus, dans le premier mode de réalisation décrit ci-dessus, le film 102 est étiré avant la solidarisation des puces électroniques 116 aux cales 120, afin d'espacer les puces électroniques 116 les unes des autres.

En variante, il est possible de ne pas étirer le film 102 car la mise en oeuvre ou non de cette étape d'étirement du film 102 dépend des dimensions et espacements souhaités des cales 120 et puces électroniques 116. Dans cette variante, les cales 120 sont disposées les unes à côté des autres en se touchant, du fait que les puces électroniques 116 ne sont pas espacées les unes des autres avant que l'ensemble formé du film 102 et des puces électroniques 116 soit reporté sur le support 118, du côté des cales 120. Les puces électroniques 116 sont toutefois découpées avant leur positionnement sur les cales 120. Les bords des cales 120 sont positionnés dans les traits de découpe présents entre les puces électroniques 116 voisines.

Dans cette variante dans laquelle les circuits électroniques 100 sont réalisés collectivement, les cales 120 sont avantageusement formées par un seul élément monolithique, par exemple un wafer de semi-conducteur, dans lequel les surfaces d'appui courbées 122 sont réalisées par exemple par lithographie. Ensuite, une différence de pression est établie entre les deux côtés du film 102 pour que les puces électroniques 116 soient plaquées contre les surfaces d'appui courbées 122 des cales 120 et épousent leur forme, comme précédemment décrit.

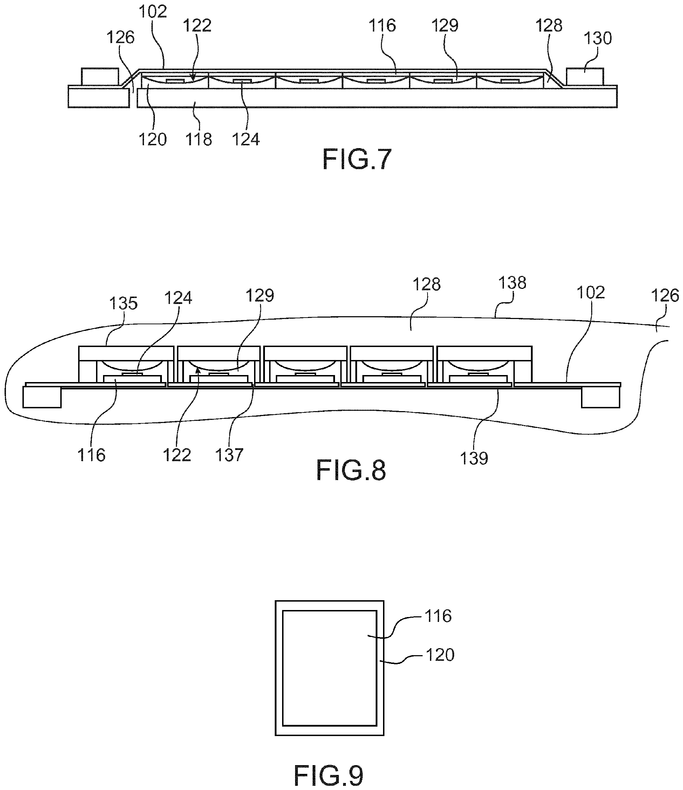

La figure 7 représente la configuration obtenue selon cette variante du premier mode de réalisation, avant l'établissement de la différence de pression entre l'intérieur et l'extérieur du volume 128. Le volume 128 inclut notamment les espaces vides 129 présents entre les puces électroniques 116 et les surfaces d'appui courbées 122 et qui communiquent entre eux dans le volume 128.

Le procédé selon cette variante est achevé comme précédemment décrit en lien avec la figure 1J.

Dans cette variante, le fait que le film 102 ne soit pas étiré avant le positionnement des puces électroniques 116 sur les surfaces d'appui courbées 122 permet de conserver le positionnement relatif des cales 120 et des puces 116 entre-elles, ce qui garantit, à l'issue du collage, un très bon alignement de chacune des puces électroniques 116 dans la cale 120 qui lui est associées. Cela est très avantageux, par exemple pour réaliser un alignement par rapport à un système optique.

En outre, dans le premier mode de réalisation décrit ci-dessus, les surfaces d'appui courbées 122 des différentes cales 120 sont similaires les unes des autres. Par exemple, pour une puce électronique 116 de dimensions latérales égales à 30 mm x 37 mm et une épaisseur égale à 0,1 mm, le rayon de courbure R de la surface d'appui courbée 122 sur laquelle cette puce électronique 116 est reportée peut être tel que R = 150 mm. En variante, il est possible que ces surfaces d'appui courbées 122 aient des rayons de courbure différents, ou encore que certaines cales 120 n'aient pas de surface courbe mais une surface plane. De manière générale, le rayon de courbure R est par exemple compris entre environ 1 mm et 5000 mm.

En variante de la ou des ouvertures 126 servant à mettre sous vide le volume 128 dans lequel se trouvent les cales 120 et les puces électroniques 116, il est possible d'utiliser un support 118 poreux, par exemple un substrat comprenant de la céramique, par exemple de l'alumine ou du carbure de silicium.

En outre, les formes des surfaces courbées 122 des cales 120 peuvent être concaves ou convexes, sphérique, cylindrique, en forme d'une portion de tore, ou encore de forme libre ou asphérique.

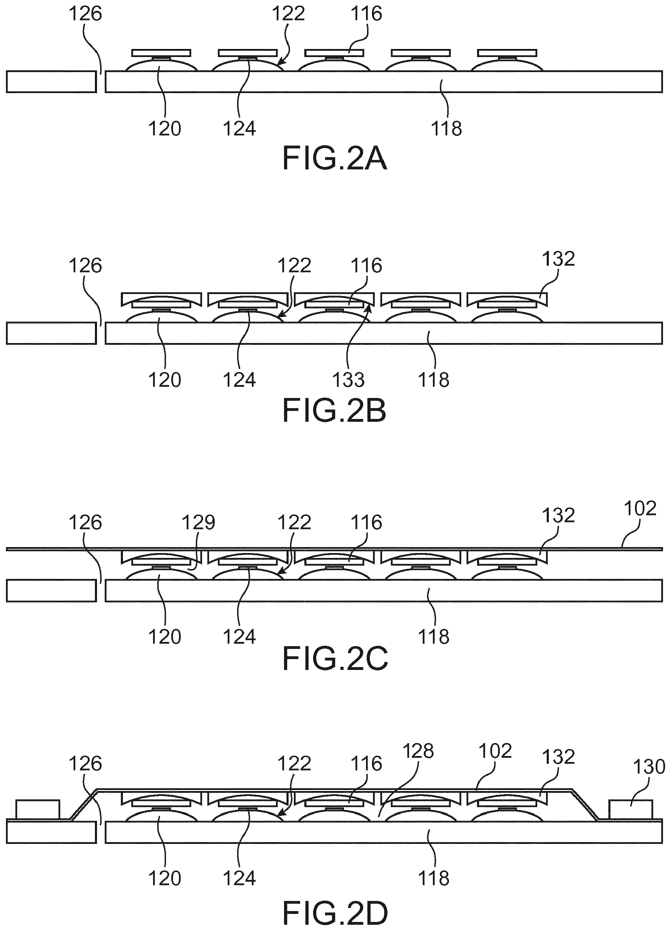

Les figures 2A à 2D représentent une partie des étapes d'un procédé de réalisation de circuits électroniques 100 courbés, selon un deuxième mode de réalisation. Ce deuxième mode de réalisation est avantageusement mis en oeuvre lorsque les surfaces d'appui courbées 122 sont convexes.

Comme représenté sur la figure 2A, le support 118 est formé, les cales 120 étant présentes sur une face avant du support 118. Les surfaces d'appui courbées 122 sont ici convexes. Les puces électroniques 116 sont disposées individuellement sur les surfaces d'appui courbées 122 des supports 120, les moyens adhésifs 124 étant interposés entre les puces électroniques 116 et les surface d'appui courbées 122.

Des contre-cales 132, formant des éléments d'appui complémentaires aux surfaces 122, sont disposées sur les puces électroniques 116. Chacune des contre-cales 132 a une surface en contact avec l'une des puces électroniques 116 qui est par exemple de forme complémentaire à celle de la surface d'appui courbée 122 de la cale 120 associée. Ainsi, sur l'exemple de la figure 2B, la surface d'appui courbée 122 a une forme convexe et la contre-cale 132 a une surface d'appui (en contact avec la puce électronique 116) formant une surface courbée 133 concave.

Dans le deuxième mode de réalisation décrit ici, le rayon de courbure de la surface d'appui 133 de la contre-cale 132 est supérieur ou égal à celui de la surface d'appui courbée 122. Si la contre-cale 132 a une surface d'appui 133 convexe, avec un cale 120 comme celle précédemment décrite en lien avec le premier mode de réalisation, le rayon de courbure de la surface d'appui 133 de la contre-cale 132 est inférieur ou égal à celui de la surface d'appui courbée 122.

Toutefois, si le matériau de la contre-cale 132 présente une certaine souplesse, la différence entre les rayons de courbure des surfaces 122 et 133 peut être plus importante que lorsque le matériau de la contre-cale 132 est rigide car une contre-cale 132 souple vient épouser plus facilement la forme de la cale 120.

Dans le deuxième mode de réalisation décrit ici, les contre-cales 132 sont disposées individuellement sur les puces électroniques 116.

Comme représenté sur la figure 2C, le film 102 est disposé sur les contre-cales 132.

Comme dans le premier mode de réalisation, les bords du film 102 sont ensuite solidarisés de manière étanche au support rigide 118 afin que le film 102 et le support rigide 118 forment le volume 128 dans lequel les puces électroniques 116, les cales 120, les éléments adhésifs 124 et les contre-cales 132 se retrouvent enfermés (figure 2D). Ce volume 128 communique avec l'environnement extérieur uniquement à travers la ou les ouvertures 126. Comme dans le premier mode de réalisation, les bords du film 102 sont solidarisés au support rigide 118 grâce à l'anneau 130 plaquant de manière étanche les bords du film 102 au support rigide 118. Les espaces vides 129 présents entre les puces électroniques 116 et les surfaces d'appui courbées 122 communiquent entre eux dans le volume 128.

Le procédé de réalisation des circuits électroniques 100 est ensuite achevé de manière analogue au premier mode de réalisation précédemment décrit, c'est-à-dire en mettant sous vide le volume 128 afin de plaquer et courber les puces électroniques 116 contre les cales 120 (à l'aide de la pression exercée par le film 102 et les contre-cales 132 sur les puces électroniques 116), en réticulant la colle des éléments adhésifs 124, en stoppant la mise en dépression du volume 128, en réalisant la découpe unitaire des circuits électroniques 100 et en les mettant en boîtier.

Les variantes de mise en oeuvre du procédé de réalisation des circuits électroniques 100 précédemment décrites en lien avec le premier mode de réalisation peuvent s'appliquer au deuxième mode de réalisation décrit ci-dessus.

En variante du deuxième mode de réalisation, il est notamment possible que les cales 120 soient disposées les unes à côté des autres telles que deux cales voisines se touchent. Les cales 120 sont avantageusement formées par un seul élément monolithique, par exemple un wafer de semi-conducteur. Les contre-cales 132 voisines peuvent également être en contact les unes contre les autres. Les puces électroniques 116 sont découpées avant leur positionnement sur les cales 120. Une différence de pression est établie entre les deux côtés du film 102 pour que les puces électroniques 116 soient plaquées contre les surfaces d'appui courbées 122 des cales 120 et épousent leur forme, comme précédemment décrit.

Le procédé selon cette variante est achevé comme précédemment décrit en lien avec les figures 2C et 2D.

En outre, en variante du deuxième mode de réalisation, les contre-cales 132 et/ou les puces électroniques 116 peuvent être reportés sur les cales 120 non pas individuellement comme dans le procédé décrit ci-dessus, mais collectivement en solidarisant au préalable les contre-cales 132 et/ou les puces électroniques 116 au film 102 et en utilisant le film 102 pour réaliser ce report.

En variante, il est également possible de ne pas utiliser de contre-cales 132 pour courber les puces électroniques 116. Dans ce cas, comme dans le premier mode de réalisation, l'appui courbant les puces électroniques 116 contre les surfaces courbées 122 des cales 120 est réalisé directement par le film 102.

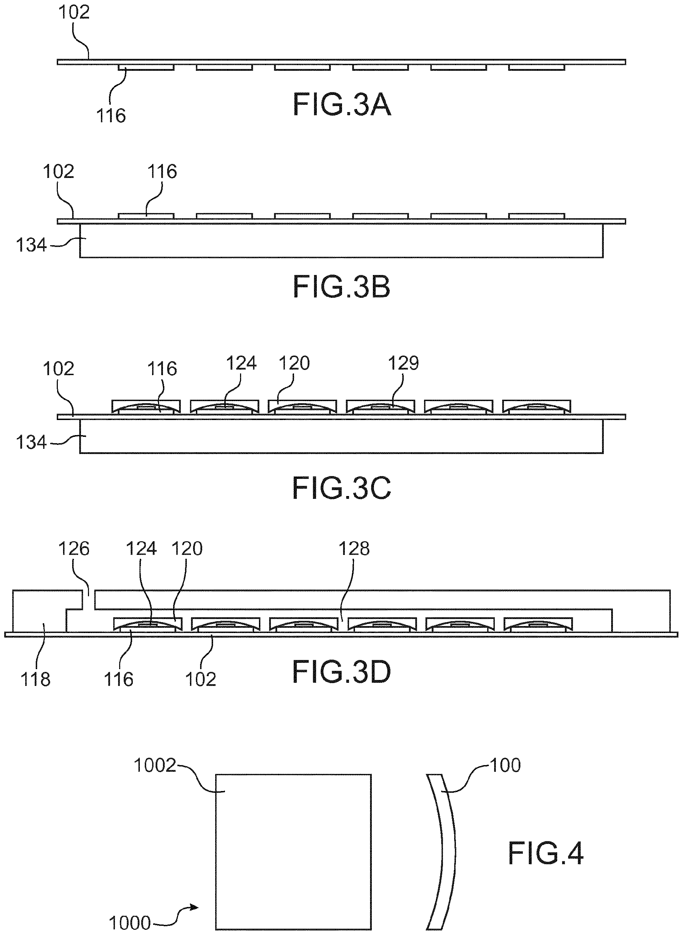

Les figures 3A à 3D représentent une partie des étapes d'un procédé de réalisation de circuits électroniques 100 courbés, selon un troisième mode de réalisation.

Les étapes précédemment décrites en lien avec les figures 1A à 1F sont tout d'abord mises en oeuvre, réalisant ainsi les puces électroniques 116 sur le film 102 qui peut être étiré (figure 3A).

Comme représenté sur la figure 3B, le film 102 est ensuite retourné et solidarisé sur un support temporaire 134 (différent du support temporaire 108 précédemment décrit en lien avec le premier mode de réalisation).

Les éléments adhésifs 124 et les cales 120 sont ensuite disposés sur les puces électroniques 116 (figure 3C).

Le support rigide 118 est ensuite reporté sur le film 102, formant ainsi le volume 128 qui sera mis en dépression pour courber les puces électroniques 116 via l'appui subi par les puces électroniques 116 et les cales 120 entre le film 102 et le support rigide 118. En reportant le support rigide 118 sur le film 102, on bénéficie de l'adhérence de la face avant du film 102 pour faciliter le transfert et l'étanchéité avec le support rigide 118. Le support temporaire 134 peut être retiré à ce stade du procédé.

Le procédé est ensuite achevé comme dans les précédents modes de réalisation, c'est-à-dire en mettant sous vide le volume 128 afin de plaquer et courber les puces électroniques 116 contre les cales 120, en réticulant la colle des éléments adhésifs 124, en stoppant la mise en dépression du volume 128, en réalisant la découpe unitaire des circuits électroniques 100 et en les mettant en boîtier final.

En variante, il est possible que le film 102 ne soit pas étiré avant le positionnement du film 102 sur le support temporaire 134. Dans ce cas, les cales 120 positionnées ensuite sur les puces électroniques 116 sont telles que les cales 120 voisines se touchent, comme précédemment décrit en lien avec la figure 7. Le procédé selon cette variante est achevé comme décrit ci-dessus.

Quel que soit le mode de réalisation du procédé réalisant les circuits électroniques 100, l'alignement entre les cales 120 et les puces électroniques 116 (qui correspond aux étapes décrites en lien avec les figures 1H, 2B et 3C) est par exemple réalisé avec une précision de l'ordre de 0,1 mm, et de préférence de 10 µm.

Dans les exemples précédemment décrits, la mise en dépression du volume 128 est obtenue en réalisant un vide primaire dans le volume 128. De manière générale, le niveau de vide est ajusté afin d'assurer un bon placage des puces électroniques 116 contre les cales 120, et l'obtention de la courbure souhaitée des puces électroniques 116.

Dans le procédé décrit précédemment selon les différents modes de réalisation, plusieurs circuits électroniques 100 sont réalisés collectivement, et les puces électroniques 116 sont notamment courbées de manière collective au cours de ce procédé. En variante, ce procédé peut être mis en oeuvre pour un seul circuit électronique 100, au cours duquel la courbure d'une seule puce électronique 116 peut être réalisée.

Dans les modes de réalisation précédemment décrits, les cales 120 sont distinctes du support rigide 118. En variante, il est possible que les cales 120 correspondent à des parties saillantes du support rigide 118. Les cales 120 peuvent en outre correspondre à un seul élément comprenant plusieurs surfaces courbées 122.

Enfin, dans les différents modes de réalisation précédemment décrits, la force appliquée par le film 102 sur les puces électroniques 116 pour les déformer est engendrée par une mise sous vide du volume 128. En variante, il est possible que cette force appliquée par le film 102 sur les puces électroniques 116 soit engendrée par une augmentation de la pression à l'extérieur du volume 128.

Dans tous les cas, les circuits électroniques courbés 100 ainsi réalisés peuvent être utilisés pour la réalisation de dispositifs électroniques 1000 tels que celui représenté schématiquement sur la figure 4. Sur cette figure, le dispositif électronique 1000 correspond à un imageur comprenant un circuit électronique courbé 100 formant un capteur d'image couplé optiquement à un système optique 1002 comprenant plusieurs lentilles focalisant une lumière reçue sur les composants électroniques du circuit 100.

Dans les modes de réalisation précédemment décrits, chaque circuit électronique courbé 100 formé d'une puce électronique 116 collée à une surface d'appui courbée 122 d'une cale 120 est mis en boîtier à l'issue des étapes décrites ci-dessus. Selon une variante pouvant d'appliquer à tous les modes de réalisation précédemment décrits, il est possible que les cales 120 correspondent aux boitiers d'encapsulation des puces électroniques 116. Dans ce cas, le film souple 102 assure la fermeture du boîtier. Chacun de ces boîtiers d'encapsulation ou chaque partie du film souple 102 fermant l'un des boîtiers est muni d'un évent, ou ouverture, afin que, lors de l'application de la différence de pression entre l'intérieur et l'extérieur du volume 128, l'air présent dans le boîtier puisse s'évacuer.

En variante des modes de réalisation précédemment décrits, il est possible que le film souple 102 entoure les ensembles formés des cales 120 (ou boîtiers) et des puces électroniques 116, une partie du film souple 102 passant entre le support rigide 118 et les cales 120. Selon une autre variante, il est possible que le film souple 102 entoure les ensembles formés des cales 120 et des puces électroniques 116 et également le support rigide 118.

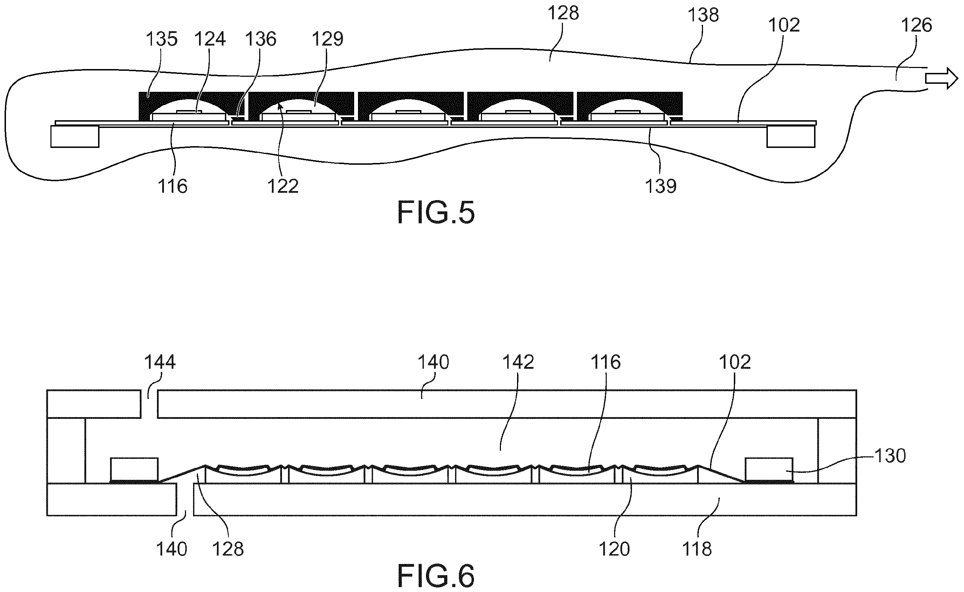

Selon un quatrième mode de réalisation, il est possible de ne pas utiliser de support rigide 118. Par exemple, comme représenté sur la figure 5, les puces électroniques 116 sont réalisées sur le film souple 102. Dans ce quatrième mode de réalisation, les surfaces d'appui courbées 122 correspondent à des surfaces intérieures de boîtiers 135 dans lesquels les puces électroniques 116 sont destinées à être encapsulées. La référence 136 désigne un évent formé dans chacun de ces boîtiers 135 permettant d'évacuer l'air présent entre les puces électroniques et les surfaces d'appui courbées 122. L'ensemble est disposé dans le volume 128 délimité par des parois souples, ici formées par un sachet souple 138. L'ouverture 126 est utilisée pour établir la différence de pression entre l'intérieur et l'extérieur du volume 128. Les parois du sachet souple 138 appuient alors sur le film souple 102 qui, en se déformant, plaque les puces électroniques 116 contre les surfaces d'appui courbées 122 des boîtiers 135. L'intérieur de chaque boîtier 135 dans lequel se trouve l'une des puces électroniques 116 est fermé par le film souple 102 qui adhère aux bords des boîtiers 135. Lorsque les évents sont formés dans le film souple 102, un film 139 perméable à l'air recouvre le film souple 102 afin que lors de l'application de la différence de pression entre l'intérieur et l'extérieur du volume 128, le sachet souple 138 ne bouche pas les évents.

En variante de ce quatrième mode de réalisation, les boîtiers 135 peuvent ne pas comporter les évents 136, comme c'est le cas sur la figure 8. Dans ce cas, lors de la mise en dépression du volume 128, l'air est évacué à travers les évents 137 formés à travers le film souple 102. En outre, sur l'exemple représenté sur la figure 8, les surfaces d'appui 122 sont convexes. Dans cette variante, les boîtiers 135 peuvent être en contact les uns à côté des autres et être par exemple formés sous la forme d'une seule pièce monolithique qui sera découpée à la suite de la solidarisation des puces électroniques 116.

Dès lors que les puces électroniques 116 sont destinées à être encapsulées entre les cales 120, ou les boîtiers 135, et le film souple 102, le film souple 102 présente des propriétés adhésives lui permettant d'adhérer aux bords des cales 120 ou des boîtiers 135, et encapsuler ainsi les puces électroniques 116 plaquées contre les surfaces d'appui courbées 122. Il est ainsi possible de placer les cales 120 ou les boîtiers 135 par un procédé de type « pick and place », sur le film souple 102 déjà étiré, ce qui améliore l'alignement des puces électroniques 116 vis-à-vis des cales 120 ou des boîtiers 135. Cela peut s'appliquer également au troisième mode de réalisation précédemment décrit.

La figure 6 représente une autre variante de réalisation dans laquelle un capot 140 est solidarisé au support rigide 118 afin de former un volume 142 pouvant être mis sous pression via une ouverture 144 formée à travers le capot 140, augmentant ainsi la différence de pression possible entre l'intérieur et l'extérieur du volume 128, ce qui permet de mieux plaquer les puces électroniques 116 contre les surfaces courbées 122 des cales 120.

Dans tous les modes de réalisation, la mise en oeuvre du procédé pour réaliser collectivement plusieurs circuits électroniques 100 autorise d'utiliser des cales 120 de dimensions proches et légèrement plus grandes que celles des puces électroniques 116. La figure 9 représente une vue de dessus d'une puce électronique 116 disposée sur une cale 120 (à noter que la courbure de la surface d'appui 122, non visible sur cette figure 9, est par exemple sphérique).

## Revendications

1. Procédé de réalisation collective de plusieurs circuits électroniques (100) courbés, comprenant :
- mise en place de plusieurs éléments adhésifs (124) entre plusieurs puces électroniques (116) et plusieurs surfaces d'appui courbées (122), avec les puces électroniques (116) disposées entre les surfaces d'appui courbées (122) et un film souple (102), et tel que les puces électroniques (116), les éléments adhésifs (124) et les surfaces d'appui courbées (122) soient disposés dans un seul volume (128) configuré pour être mis en dépression vis-à-vis de l'environnement extérieur au volume (128) et incluant des espaces vides (129) présents entre les puces électroniques (116) et les surfaces d'appui courbées(122) ;
- établissement d'une différence de pression entre l'intérieur et l'extérieur du volume (128) telle que le film souple (102) applique sur les puces électroniques (116) une pression les déformant conformément aux surfaces d'appui courbées (122) ;
- arrêt de l'application de la différence de pression entre l'intérieur et l'extérieur du volume (128), les puces électroniques (116) courbées étant maintenues contre les surfaces d'appui courbées (122) par les éléments adhésifs (124).

2. Procédé selon la revendication 1, dans lequel l'établissement de la différence de pression entre l'intérieur et l'extérieur du volume (128) comporte l'établissement d'un vide à l'intérieur du volume (128).

3. Procédé selon l'une des revendications précédentes, dans lequel, avant l'établissement de la différence de pression entre l'intérieur et l'extérieur du volume (128), les surfaces d'appui courbées (122) sont disposées entre les puces électroniques (116) et un support rigide (118), le volume (128) étant formé au moins par le support rigide (118) et le film souple (102) solidarisé au support rigide (118), la différence de pression entre l'intérieur et l'extérieur du volume (128) étant réalisée par l'intermédiaire d'au moins une ouverture (126) traversant le support rigide (118) et/ou de pores du matériau du support rigide (118).

4. Procédé selon la revendication 3, comportant en outre, après l'arrêt de l'application de la différence de pression entre l'intérieur et l'extérieur du volume (128), une étape de retrait du support rigide (118).

5. Procédé selon l'une des revendications 1 ou 2, dans lequel le volume (128) est délimité par une paroi souple (138).

6. Procédé selon l'une des revendications précédentes, comportant en outre, avant l'établissement de la différence de pression entre l'intérieur et l'extérieur du volume (128), une mise en place de contre-cales (132) telles que les puces électroniques (116) soient disposées entre les surfaces d'appui courbées (122) et la ou les contre-cales (132), et dans lequel les contre-cales (132) ont des surfaces courbées (133) disposées contre les puces électroniques (116) lors de l'établissement de la différence de pression entre l'intérieur et l'extérieur du volume (128).

7. Procédé selon l'une des revendications précédentes, dans lequel les surfaces d'appui courbées (122) correspondent à des surfaces de cales (120) ou à des surfaces intérieures de boîtiers (135) dans lesquels les puces électroniques (116) sont destinées à être encapsulées.

8. Procédé selon l'une des revendications précédentes, dans lequel les puces électroniques (116) sont réalisées contre le film souple (102) via la mise en oeuvre des étapes suivantes :
- solidarisation du film souple (102) contre un substrat semi-conducteur (106), du côté de composants électroniques réalisés sur le substrat semi-conducteur (106) et destinés à former les puces électroniques (116) ;
- découpe du substrat semi-conducteur (106), formant les puces électroniques (116).

9. Procédé selon l'une des revendications précédentes, dans lequel l'étape de mise en place comporte :
- une solidarisation du film souple (102) contre un support temporaire (134) telle que le film souple (102) soit disposé entre les puces électroniques (116) et le support temporaire (134) ;
- une disposition des surfaces d'appui courbées (122) en regard des puces électroniques (116) ;
- une disposition d'un support rigide (118) tel qu'il forme, avec le film souple (102), ledit volume (128) ;
- un retrait du support temporaire (134).

10. Procédé selon l'une des revendications précédentes, dans lequel les éléments adhésifs (124) sont disposés contre les puces électroniques (116) et/ou contre les surfaces d'appui courbées (122).

11. Procédé de réalisation d'au moins un dispositif électronique (1000), comportant la mise en oeuvre d'un procédé de réalisation de circuits électroniques (100) selon l'une des revendications précédentes, puis d'une étape de couplage optique d'au moins un des circuits électroniques (100) avec un système optique (1002), formant le dispositif électronique (1000).
